# EUROPÄISCHE PATENTSCHRIFT

(11) **EP 3 507 227 B1**
(45) Veröffentlichungstag und Bekanntmachung des Hinweises auf die Patenterteilung: **06.01.2021**
(21) Anmeldenummer: 17755547.1
(22) Anmeldetag: 29.08.2017
(51) Int. Cl.: B66B 19/00

(54) **VERFAHREN ZUR ANALYSE UND MESSSYSTEM ZUM VERMESSEN EINES AUFZUGSCHACHTS EINER AUFZUGANLAGE**
METHOD FOR ANALYZING AND MEASURING SYSTEM FOR MEASURING AN ELEVATOR SHAFT OF AN ELEVATOR ASSEMBLY
PROCEDE D'ANALYSE ET SYSTEME DE MESURE DESTINE A MESURER UNE CAGE D'ASCENSEUR

(30) Priorität: 30.08.2016 EP 16186223
(43) Veröffentlichungstag der Anmeldung: 10.07.2019
(73) Patentinhaber: Inventio AG, 6052 Hergiswil (CH)
(72) Erfinder: STUDER, Christian, 6010 Kriens (CH); BITZI, Raphael, 6006 Luzern (CH); BÜTLER, Erich, 6030 Ebikon (CH)
(86) Internationale Anmeldenummer: PCT/EP2017/071629
(87) Internationale Veröffentlichungsnummer: WO 2018/041815

(56) Entgegenhaltungen:
- WO-A1-2014/027142
- US-A1- 2016 139 269

## Beschreibung

Die Erfindung betrifft ein Verfahren zur Analyse eines hauptsächlich in einer Haupterstreckungsrichtung verlaufenden Aufzugschachts einer Aufzuganlage gemäss dem Oberbegriff des Anspruchs 1 und ein Messsystem zum Vermessen eines hauptsächlich in einer Haupterstreckungsrichtung verlaufenden Aufzugschachts einer Aufzuganlage gemäss dem Oberbegriff des Anspruchs 12.

Die WO 2014/027142 A1 beschreibt ein Verfahren zur Analyse eines Aufzugschachts einer Aufzuganlage, bei dem der Aufzugschacht mit einem Messsystem vermessen wird. Das Messsystem weist eine Scan-Vorrichtung, beispielsweise in Form eines Kamerasystems mit einer oder mehreren Kameras auf. Mittels der Scan-Vorrichtung werden Entfernungen zu und/oder relative Positionen bezüglich Elementen des Aufzugschachts, wie beispielsweise Schachtwänden ermittelt. Die Position der Scan-Vorrichtung im Aufzugschacht wird beispielsweise mit Hilfe eines Beschleunigungssensors bestimmt. Auf Basis der Position der Scan-Vorrichtung und den ermittelten Entfernungen und/oder relativen Positionen wird ein digitales Modell des Aufzugschachts erstellt. Anschliessend wird auf Basis des digitalen Modells geprüft, ob der Aufzugschacht und eventuell schon im Aufzugschacht montierte Teile der Aufzuganlage wie vorgesehen ausgeführt sind.

Demgegenüber ist es insbesondere die Aufgabe der Erfindung, ein Verfahren zur Analyse und ein Messsystem zum Vermessen eines Aufzugschachts einer Aufzuganlage vorzuschlagen, welche ein besonders genaues Vermessen eines Aufzugschachts ermöglichen. Erfindungsgemäss wird diese Aufgabe mit einem Verfahren mit den Merkmalen des Anspruchs 1 und einem Messsystem mit den Merkmalen des Anspruchs 12 gelöst.

Beim erfindungsgemässen Verfahren zur Analyse eines hauptsächlich in einer Haupterstreckungsrichtung verlaufenden Aufzugschachts einer Aufzuganlage wird der Aufzugschacht mittels eines, ein Kamerasystem aufweisenden Messsystems vermessen. Auf Grund bei der Vermessung ermittelten Daten wird ein digitales Modell des Aufzugschachts erstellt. Erfindungsgemäss erfolgt die Vermessung mittels eines Messsystems, welches zusätzlich zum genannten Kamerasystem eine inertiale Messeinheit mit Beschleunigungs- und Drehratensensoren aufweist. Das Messsystem ist damit als ein so genanntes optisch inertiales Messsystem ausgeführt. Mittels der inertialen Messeinheit kann eine Position des optisch inertialen Messsystems im Aufzugschacht abgeschätzt werden. Zur Erstellung des digitalen Modells des Aufzugschachts wird zusätzlich zu den Informationen der Beschleunigungs- und Drehratensensoren der inertialen Messeinheit wenigstens eine weitere Information über die Position des optisch inertialen Messsystems in Haupterstreckungsrichtung erfasst und ausgewertet. Unter Informationen der Beschleunigungs- und Drehratensensoren sollen hier insbesondere von den Sensoren gemessene Grössen, wie Beschleunigungen und Drehraten, sowie aus den gemessenen Grössen abgeleitete Grössen, verstanden werden.

Das genannte digitale Modell des Aufzugschachts wird auf Basis der Position des Messsystems und der Lage beziehungsweise relativen Position von markanten Punkten, wie beispielsweise Ecken oder Erhebungen in einer Schachtwand, bezüglich des Messsystems erstellt. Die Lage der markanten Punkte, also insbesondere die Abstände bezüglich des Messsystems in drei jeweils senkrecht zueinander angeordneten Koordinatenrichtungen, kann vom Messsystem sehr präzise und zuverlässig ermittelt werden. Für die Erstellung eines korrekten digitalen Modells ist aber die Kenntnis der Position des Messsystems von sehr grosser Bedeutung. Ein Fehler in der Bestimmung der Position des Messsystems führt zu einem entsprechenden Fehler im digitalen Modell. Inertiale Messeinheiten weisen üblicherweise drei jeweils senkrecht zueinander angeordnete Beschleunigungssensoren und jeweils drei senkrecht zueinander angeordnete Drehratensensoren auf, mittels welchen die Beschleunigungen in x-, y- und z-Richtung und die Drehbeschleunigungen um die x-, y- und z-Achse bestimmt und daraus ausgehend von einer Startposition die aktuelle Position der inertialen Messeinheit ermittelt oder zumindest abgeschätzt werden kann. Zusätzlich kann die inertiale Messeinheit auch über drei jeweils senkrecht zueinander angeordnete Magnetfeldsensoren verfügen. Die Bestimmung der Beschleunigung in vertikaler, also in z-Richtung wird dabei stark von der Erdbeschleunigung beeinflusst, was zu Fehlern in der Bestimmung bzw. Abschätzung der Position der Messeinheit in z-Richtung führen kann. Dieser Fehler in der z-Position des Messsystems führt dann wie beschrieben auch zu einem Fehler im digitalen Modell des Aufzugschachts, so dass ein auf Basis von nicht korrekten Informationen über die Position des Messsystems ermitteltes digitales Modell nicht exakt den Aufzugschacht wiedergibt.

Durch die erfindungsgemässe Erfassung und Auswertung wenigstens einer weiteren Information über die Position des optisch inertialen Messsystems in Haupterstreckungsrichtung des Aufzugschachts kann die Position des Messsystems besonders genau bestimmt werden. Auf Basis der sehr genauen Bestimmung der Position des Messsystems kann damit ein sehr exaktes digitales Modell des Aufzugschachts erstellt werden.

Die genannte weitere Information über die Position des optisch inertialen Messsystems in Haupterstreckungsrichtung kann ganz unterschiedlich ausgeführt, erfasst und ausgewertet werden. Es ist beispielsweise möglich, dass zusätzlich zur Abschätzung der Position des Messsystems in Haupterstreckungsrichtung mittels der inertialen Messeinheit eine weitere Messung der Position des Messsystems in Haupterstreckungsrichtung erfolgt. Dafür stehen verschiedene, beispielsweise für den normalen Betrieb von Aufzuganlagen vorgesehene Verfahren und Systeme zur Verfügung. Ergänzend oder alternativ dazu kann auch eine indirekte Information über die Position des Messsystems in Haupterstreckungsrichtung erfasst und ausgewertet werden. Dazu kann die relative Position des Messsystems gegenüber einem oder mehreren mit dem Kamerasystem erfassten Referenzelementen bestimmt und ausgewertet werden. Voraussetzung dafür ist, dass Informationen über absolute oder relative Positionen des oder der Referenzelemente vorhanden sind. Aus diesen Informationen und der Lage des Messsystems zu dem oder den Referenzelementen kann auf die Position des Messsystems in Haupterstreckungsrichtung geschlossen. beziehungsweise deren Position bestimmt werden. Die mittels der genannten weiteren Information über die Position des optisch inertialen Messsystems in Haupterstreckungsrichtung bestimmte Position in Haupterstreckungsrichtung des Messsystems kann beispielsweise statt der mittels der inertialen Messeinheit bestimmten Position für die Vermessung des Aufzugsschachts verwendet werden. Es ist aber auch möglich, dass aus beiden genannten Positionen eine Position für die Vermessung bestimmt wird. Beispielsweise kann ein Mittelwert dieser Positionen verwendet werden. Darüber hinaus ist es möglich, dass die genannte weitere Information über die Position des optisch inertialen Messsystems in Haupterstreckungsrichtung zur Justierung und/oder Kalibrierung der inertialen Messeinheit in Haupterstreckungsrichtung genutzt wird.

Das für die Vermessung des Aufzugschachts eingesetzte Kamerasystem des Messsystems kann als eine einzelne Kamera, mehrere Kameras, zwei zu einer Stereo-Kamera kombinierte Kameras oder mehrere Stereo-Kameras ausgeführt sein. Die Kameras sind dabei als Digitalkameras ausgeführt. Insbesondere sind Taktraten der Kameras und der inertialen Messeinheit synchronisiert beziehungsweise aufeinander abgestimmt. Die Bestimmung der Lage eines markanten Punkts bezüglich des Messsystems erfolgt dabei insbesondere mittels Triangulation. Dabei wird der markante Punkt von zwei verschiedenen Kamera-Positionen erfasst und angepeilt. Auf Basis des Abstands der beiden verschiedenen Kamera-Positionen zueinander und der relativen Positionen des markanten Punktes bezüglich jeder Kamera-Position, kann auf bekannte Weise die Lage des markanten Punkts zum Messsystem bestimmt werden. Bei der Verwendung einer Kamera muss die Kamera so bewegt werden, dass sie den markanten Punkt von mindestens zwei verschiedenen Kamera-Positionen erfassen kann, so dass die oben genannte Triangulation ausgeführt werden kann. Bei einer Stereo-Kamera sind zwei Kameras in einem definierten Abstand zueinander angeordnet, so dass ein markanter Punkt gleichzeitig von beiden Kameras an verschiedenen Kamera-Positionen erfasst und die Triangulation ausgeführt werden kann.

Zum Vermessen des Aufzugschachts wird das Messsystem insbesondere innerhalb des Aufzugschachts verlagert, um so den ganzen Aufzugschacht vermessen zu können. Die Verlagerung erfolgt insbesondere in Haupterstreckungsrichtung und durch eine Verlagerungsvorrichtung, beispielsweise in Form einer Winde. Das Messsystem ist beispielsweise über ein Tragmittel, insbesondere in Form eines Seils oder einer Kette aufgehängt, über welches die insbesondere in einem Schachtkopf des Aufzugschachts angeordnete Verlagerungsvorrichtung das Messsystem in Haupterstreckungsrichtung verlagern, also insbesondere in vertikaler Richtung hoch- und runterlassen kann. Eine spezielle Führung des Messsystems, also beispielsweise eine Vorrichtung zum Verhindern einer Rotation um eine Achse parallel zur Haupterstreckungsrichtung oder zum Verhindern einer Verlagerung quer zur Haupterstreckungsrichtung ist nicht zwingend notwendig, kann aber vorgesehen sein. In einer einfachen Ausführungsform einer solchen Führung kann das Messsystem beispielsweise über zwei parallel verlaufende Tragmittel aufgehängt sein, was einer Rotation und Verlagerung des Messsystems entgegenwirkt.

Unter einer Analyse eines Aufzugschachts soll in diesem Zusammenhang insbesondere die Vermessung des Aufzugschachts und optional eine anschliessende Prüfung und Auswertung der bei der Vermessung gewonnenen Daten verstanden werden. Das Ergebnis der Vermessung ist dabei ein digitales Modell des Aufzugschachts. Das digitale Modell enthält dabei insbesondere Informationen über die Position von markanten Punkten, wie beispielsweise Ecken oder Erhebungen in einer Schachtwand, welche beispielsweise in Form einer so genannten Punktwolke vorliegen können. Jeder einzelne Punkt dieser Punktwolke ist dabei ein vermessener markanter Punkt. Diese Punktwolke muss nicht, kann aber mit geeigneten Verfahren nachbearbeitet werden und dabei beispielsweise Informationen über die Abmessungen des Aufzugschachts und über Positionen von Türausschnitten abgeleitet werden.

Unter der Haupterstreckungsrichtung eines Aufzugschachts soll in diesem Zusammenhang die Richtung verstanden wird, in der eine Aufzugkabine der fertig montierten Aufzuganlage verfahren wird. Die Haupterstreckungsrichtung verläuft also insbesondere vertikal, sie kann aber auch gegenüber der Vertikalen geneigt oder horizontal verlaufen.

In Ausgestaltung der Erfindung weist das optisch inertiale Messsystem wenigstens drei Stereo-Kameras, also wenigstens sechs einzelne Kameras auf, welche beim Vermessen des Aufzugschachts so quer zur Haupterstreckungsrichtung angeordnet sind, dass eine Rundumsicht gewährleistet ist. Die Rundumsicht bezieht sich also um eine Achse parallel zur Haupterstreckungsrichtung des Aufzugschachts. Damit ist es vorteilhafterweise möglich, dass das Messsystem von einer Position aus einen kompletten Abschnitt in Haupterstreckungsrichtung des Aufzugschachts erfassen kann. Damit ist eine besonders schnelle und insbesondere auch genaue Vermessung des Aufzugsschachts möglich. Unter einer Rundumsicht soll in diesem Zusammenhang verstanden werden, dass das Messsystem ohne sich bewegen zu müssen, Objekte in allen Richtungen quer zur Haupterstreckungsrichtung, also insbesondere in horizontaler Richtung erfassen und auswerten kann. Bei einem quaderförmigen Aufzugschacht kann das Messsystem also alle vier, den Aufzugschacht begrenzenden Schachtwände auf einmal erfassen. Die Rundumsicht wird durch die Verwendung von mindestens drei Stereo-Kameras ermöglicht, die so ausgerichtet sind, dass ihre einzelnen Erfassungsbereiche einen Winkelbereich von 360° um die Haupterstreckungsrichtung herum abdecken. Dabei überlappen sich insbesondere die einzelnen Erfassungsbereiche der Stereo-Kameras. Bei der Verwendung von drei Stereo-Kameras können diese beispielsweise senkrecht zu Seiten eines gleichseitigen Dreiecks angeordnet sein. Bei der Verwendung von vier Stereo-Kameras können diese beispielsweise senkrecht zu Seiten eines Quadrats angeordnet sein. Darüber hinaus sind andere Anordnungen denkbar, die eine Rundumsicht ermöglichen.

Alternativ zur Anordnung der Kameras quer zur Haupterstreckungsrichtung können eine oder mehrere Kameras in Haupterstreckungsrichtung ausgerichtet sein. Die Kameras können also beispielsweise im Aufzugschacht von oben nach unten ausgerichtet sein.

In Ausgestaltung der Erfindung ist das optisch inertiale Messsystem mit einer Positionsbestimmungseinheit gekoppelt, welche eine Position des Messsystems in Haupterstreckungsrichtung bestimmt. Diese Position wird als weitere Information über die Position des optisch inertialen Messsystems in Haupterstreckungsrichtung erfasst und ausgewertet. Positionsbestimmungseinheiten können eine Position sehr genau und insbesondere ohne Beeinflussung durch die Erdbeschleunigung bestimmen. Derartige Positionsbestimmungseinheiten, welche beispielsweise als Ultraschall- oder Lasermesseinheiten ausgeführt sind oder einen in Haupterstreckungsrichtung ausgerichteten Positionsinformationsträger, beispielsweise in Form eines Codebands mit magnetischen oder optischen Codemarken, auswerten, sind in grosser Anzahl und zu vergleichsweisen günstigen Preisen auf dem Markt erhältlich. Die Vermessung des Aufzugschachts kann damit kostengünstig und sehr genau erfolgen.

Unter einer Kopplung des Messsystems mit einer Positionsbestimmungseinheit soll in diesem Zusammenhang eine örtliche und/oder signaltechnische Kopplung verstanden werden. Die Positionsbestimmungseinheit kann also beispielsweise auf dem Messsystem angeordnet sein. Es ist aber auch möglich, dass zumindest Teile der Positionsbestimmungseinheit räumlich getrennt vom Messsystem, also beispielsweise im Aufzugschacht, insbesondere an der Verlagerungsvorrichtung angeordnet und nur signaltechnisch mit dem Messsystem verbunden sind. Die Positionsbestimmungseinheit kann Rohsignale an das Messsystem übertragen, die vom Messsystem ausgewertet werden. Es ist auch möglich, dass die Positionsbestimmungseinheit eine Auswerteelektronik aufweist, welche ein aufbereitetes Signal an das Messsystem liefert. Es ist auch möglich, dass eine relative Messung der Position des Messsystems in Haupterstreckungsrichtung durchgeführt wird. Dazu kann beispielsweise die Verlagerung eines das Messsystem haltenden Tragmittels bestimmt und damit ausgehend von einer Startposition die aktuelle Position des Messsystems bestimmt werden.

In Ausgestaltung der Erfindung bestimmt die Positionsbestimmungseinheit eine Information über die Position des Messsystems in Haupterstreckungsrichtung mittels eines langestreckten und in Haupterstreckungsrichtung ausgerichteten Positionsinformationsträgers. Die Stereo-Kameras und der Positionsinformationsträger sind dabei so zueinander angeordnet, dass der Positionsinformationsträger von keinem der Stereo-Kameras erfasst wird. Wenn eine Stereo-Kamera den Positionsinformationsträger erfassen würde, so müsste das erkannt und die eventuell am Positionsinformationsträger erfassten markanten Punkte nachträglich eliminiert werden. Dies ist zum einen aufwändig und kann zu Fehlern bei der Erstellung des digitalen Modells des Aufzugschachts führen. Damit ermöglicht diese Ausgestaltung der Erfindung ein einfaches und insbesondere wenig fehleranfälliges Verfahren zur Vermessung eines Aufzugschachts.

Wenn die Stereo-Kameras wie oben beschrieben an den Seiten eines Drei- oder Vierecks angeordnet sind, so wird der Positionsinformationsträger innerhalb der Fläche des Drei- oder Vierecks durchgeführt. Der Positionsinformationsträger verläuft also insbesondere hinter beziehungsweise im Rücken jeder der Stereo-Kameras. Er kann insbesondere auch zusammen mit einem Tragmittel, an dem das Messsystem aufgehängt ist und gegenüber dem der Positionsinformationsträger versetzt angeordnet ist, als eine Führung zur Verhinderung einer ungewollten Rotation und/oder Verlagerung des Messsystems dienen.

Der Positionsinformationsträger ist insbesondere als ein Codeband mit magnetischen oder optischen Codemarken ausgeführt, das im Aufzugschacht in Haupterstreckungsrichtung gespannt ist. Die Positionsbestimmungseinheit weist in diesem Fall eine Leseeinheit auf, welche Informationen in Form der Codemarken ausliest und auswertet. Die Leseeinheit ist dabei insbesondere auf dem Messsystem angeordnet und dann insbesondere so, dass sie ebenfalls von keiner Stereo-Kamera erfasst werden kann. Sie ist also insbesondere hinter beziehungsweise im Rücken jeder der Stereo-Kameras angeordnet.

In Ausgestaltung der Erfindung wird vor der Vermessung mit dem optischen inertialen Messsystem wenigstens ein Referenzelement im Aufzugschacht angeordnet. Dieses Referenzelement wird bei der Vermessung vom optischen inertialen Messsystem erfasst und die über das Referenzelement erfasste Information als weitere Information über die Position des optisch inertialen Messsystems in Haupterstreckungsrichtung zur Erstellung des digitalen Modells des Aufzugschachts ausgewertet. Damit wird eine sehr genaue Vermessung des Aufzugschachts ermöglicht.

Es wird insbesondere nicht nur ein, sondern mehrere Referenzelemente im Aufzugschacht angeordnet. Als Referenzelement kann beispielsweise eine Markierung verwendet werden, die von einer Kamera des Messsystems einfach und eindeutig als ein markanter Punkt erfasst und ausgewertet werden kann. Das Messsystem bestimmt dann seine Lage gegenüber dem oder den Referenzelementen und schliesst daraus auf seine Position in Haupterstreckungsrichtung im Aufzugschacht.

Es wird insbesondere ein Referenzelement an einer bekannten Position in Haupterstreckungsrichtung im Aufzugschacht angeordnet und diese bekannte Position wird zur Erstellung des digitalen Modells des Aufzugschachts ausgewertet. Beispielsweise kann ein Referenzelement in einem definierten Abstand beispielsweise von einer Schachtdecke oder einem Schachtboden angeordnet werden. Erkennt dann das Messsystem während der Vermessung des Aufzugschachts das Referenzelement und kennt dessen Position, so kann es daraus und aus seiner Lage gegenüber dem Referenzelement seine Position in Haupterstreckungsrichtung ableiten. Anstatt ein Referenzelement an einer bekannten Position gegenüber Schachtdecke oder Schachtboden anzuordnen, kann ein Referenzelement auch an einer bekannten absoluten Höhe über Normal-Null angeordnet werden. Vor dem Beginn des Innenausbaus eines Gebäudes und damit auch vor dem Einbau einer Aufzuganlage wird ein Gebäude üblicherweise von einem Geometer vermessen und mit Markierungen versehen. Dabei wird insbesondere der so genannte Meterriss angebracht, welcher eine Referenzhöhe für Installationen angibt, deren Montagehöhe einer planerischen Vorgabe entsprechen müssen. Beispiele dafür sind Sanitäreinrichtungen wie Wand-WC, Armaturen und Abflüsse, aber auch Türzargen oder die Position einer Schachttür einer Aufzuganlage. Der Meterriss ist insbesondere eine Markierung, die genau 1 Meter über der späteren Oberkante des Fertigfußbodens angeordnet ist. Zusätzlich zu dieser relativen Position kann auch eine Information über die Höhe des Meterrisses über Normal-Null vorhanden und verarbeitet werden.

Es können auch wenigstens zwei Referenzelemente in einem bekannten Abstand zueinander in Haupterstreckungsrichtung im Aufzugschacht angeordnet werden. Dieser bekannte Abstand wird dann zur Erstellung des digitalen Modells des Aufzugschachts ausgewertet. Die beiden Referenzelemente können vom Messsystem erfasst werden. Das Messsystem schätzt auf Grund der Messdaten dann den Abstand zwischen den beiden Referenzelementen ab und vergleicht diesen mit dem bekannten Abstand der Referenzelemente. Aus diesem Vergleich kann auf die genaue Position des Messsystems in Haupterstreckungsrichtung geschlossen werden. Dieses Vorgehen ist besonders vorteilhaft einsetzbar, wenn vor dem Vermessen eine Leine in Haupterstreckungsrichtung im Aufzugschacht gespannt wird, die in definierten Abständen von beispielsweise einem Meter Referenzelemente, beispielsweise in Form von Markierungen aufweist. Die Leine kann auch insbesondere so angeordnet werden, dass die Markierungen einen bekannten Abstand zum Schachtboden oder der Schachtdecke aufweisen. Beispielsweise kann die Leine so angeordnet werden, dass die unterste Markierung einen Abstand von einem Meter vom Schachtboden aufweist. Damit ist sowohl die Position der Markierungen gegenüber dem Schachtboden oder der Schachtdecke und zusätzlich auch der Abstand zwischen den Markierungen bekannt. Es ist aber auch möglich, auf eine andere Weise mehr als zwei Referenzelemente mit definiertem Abstand in Haupterstreckungsrichtung zueinander im Aufzugschacht anzuordnen.

In Ausgestaltung der Erfindung wird vor der Vermessung mit dem optische inertialen Messsystem ein langgestrecktes, hauptsächlich in Haupterstreckungsrichtung verlaufendes Ausrichtelement im Aufzugschacht angeordnet, welches zur Verifizierung der ermittelten Position des optisch inertialen Messsystems verwendet wird. Dies ermöglicht eine besonders genaue Vermessung des Aufzugschachts.

Das Ausrichtelement dient dabei insbesondere zur Verifizierung der Position des Messsystems quer zur Haupterstreckungsrichtung des Aufzugschachts. Neben den oben genannten Ungenauigkeiten bei der Bestimmung der Position des Messsystems mittels der inertialen Messeinheit in vertikaler, also z-Richtung kann es auch zu kleineren Ungenauigkeiten in x- und/oder y- Richtung kommen. Durch Anordnung und Auswertung des genannten Ausrichtelements können diese Ungenauigkeiten erkannt und eliminiert werden. Die genannte Verifizierung der ermittelten Position des optisch inertialen Messsystems kann dabei während des Vermessens oder auch nachträglich bei der Erstellung des digitalen Modells des Aufzugschachts erfolgen.

Das genannte Ausrichtelement kann insbesondere mehrere Referenzelemente aufweisen, die in einem definierten Abstand zueinander angeordnet sind. Beispielsweise kann das Ausrichtelement als eine Leine ausgeführt sein, an der im Abstand von beispielsweise einem Meter jeweils ein Referenzelement in Form einer Markierung angeordnet ist. Das Ausrichtelement kann damit vorteilhafterweise zwei Funktionen erfüllen. Es kann zum einen eine genaue Bestimmung der Position des Messsystems in Haupterstreckungsrichtung und zum anderen eine Verifizierung der Position des Messsystems quer zur Haupterstreckungsrichtung ermöglichen. Das Ausrichtelement kann insbesondere so angeordnet werden, dass die Markierungen einen bekannten Abstand zum Schachtboden oder zur Schachtdecke aufweisen.

In Ausgestaltung der Erfindung wird nach der Erstellung des digitalen Modells des Aufzugschachts ein Vergleich mit einem Soll-Modell des Aufzugschachts durchgeführt. Damit kann vorteilhafterweise geprüft werden, ob der reale Aufzugschacht den Vorgaben entspricht. Falls zu grosse Abweichungen vorhanden sind, kann beispielsweise eine Nacharbeit verlangt und/oder eine Abnahme des Aufzugschachts verweigert werden.

In Ausgestaltung der Erfindung wird nach der Erstellung des digitalen Modells des Aufzugschachts geprüft, ob ein geplanter Aufbau der Aufzuganlage in dem vermessenen Aufzugschacht umgesetzt werden kann. Damit kann mit der Montage der Aufzuganlage erst begonnen werden, wenn sicher ist, dass die Montage auch wie geplant abgeschlossen werden kann. Damit können unnötige Kosten verhindert werden. Unter dem geplanten Aufbau der Aufzuganlage soll beispielsweise eine Grösse der Aufzugkabine und eines Gegengewichts, eine Anordnung von Führungsschienen und der Halter für die Aufzugkabine und das Gegengewicht, sowie die Anordnung weiterer Elemente der Aufzuganlage verstanden werden.

In Ausgestaltung der Erfindung werden, wenn der geplante Aufbau der Aufzuganlage in dem vermessenen Aufzugschacht nicht umgesetzt werden kann, Anpassungen am Aufzugschacht und/oder am Aufbau der Aufzuganlage durchgeführt. Damit können Anpassungen und damit hohe Kosten und Zeitverluste, die nach Beginn des Aufbaus der Aufzuganlage anfallen würden, verhindert werden. Es wird damit ein kostengünstiger und schneller Aufbau der Aufzuganlage ermöglicht. Unter Anpassungen soll in diesem Zusammenhang beispielsweise verstanden werden, dass an Wänden des Aufzugschachts Änderungen vorgenommen, die Grösse der Aufzugkabine und/oder des Gegengewichts angepasst, andere Halter für Führungsschienen vorgesehen oder geplante Positionen der genannten Halter verschoben werden.

Die oben genannte Aufgabe der Erfindung wird auch von einem Messsystem zum Vermessen eines hauptsächlich in einer Haupterstreckungsrichtung verlaufenden Aufzugschachts einer Aufzuganlage mit einem Kamerasystem gelöst, welches zusätzlich eine inertiale Messeinheit mit Beschleunigungs- und Drehratensensoren und eine Auswerteeinheit aufweist. Mittels der inertialen Messeinheit kann eine Position des Messsystems im Aufzugschacht abgeschätzt werden kann. Die Auswerteeinheit ist dafür vorgesehen, zur Erstellung eines digitalen Modells des Aufzugschachts zusätzlich zu den Informationen der Beschleunigungs- und Drehratensensoren der inertialen Messeinheit eine weitere Information über die Position des Messsystems in Haupterstreckungsrichtung zu erfassen und auszuwerten.

Das erfindungsgemässe Messsystem ermöglicht insbesondere eine besonders genaue Vermessung eines Aufzugschachts. Hinsichtlich möglicher Ausführungsformen und weiterer Vorteile wird auf die obigen Ausführungen bezüglich des Verfahrens unter Verwendung eines derartigen Messsystems verwiesen.

In Ausgestaltung der Erfindung weist das Messsystem wenigstens drei Stereo-Kameras auf, welche beim Vermessen des Aufzugschachts so quer zur Haupterstreckungsrichtung angeordnet sind, dass bezogen auf die Haupterstreckungsrichtung eine Rundumsicht gewährleistet ist. Die Stereokameras können dabei quer, also in einem Winkel von 90° gegenüber der Haupterstreckungsrichtung, aber auch leicht geneigt, insbesondere nach unten angeordnet sein. Das Messsystem verfügt ausserdem über eine Leseeinheit einer Positionsbestimmungseinheit zum Auslesen von Informationen eines Positionsinformationsträgers, mittels welcher eine Position des Messsystems in Haupterstreckungsrichtung bestimmbar ist. Damit wird eine besonders schnelle Vermessung eines Aufzugschachts ermöglicht.

In Ausgestaltung der Erfindung sind die Leseeinheit der Positionsbestimmungseinheit und die Stereo-Kameras so zueinander angeordnet, dass die Leseeinheit von keiner der Stereo-Kameras erfassbar ist. Sie ist also insbesondere hinter beziehungsweise im Rücken jeder der Stereo-Kameras angeordnet. Wenn eine der Stereo-Kameras die Leseeinheit erfassen würde, so müsste das erkannt und eventuell an der Leseeinheit erfasste markante Punkte nachträglich eliminiert werden. Dies ist zum einen aufwändig und kann zu Fehlern bei der Erstellung des digitalen Modells des Aufzugschachts führen. Damit ermöglicht diese Ausgestaltung der Erfindung eine einfache und insbesondere wenig fehleranfällige Vermessung eines Aufzugschachts.

Weitere Vorteile, Merkmale und Einzelheiten der Erfindung ergeben sich anhand der nachfolgenden Beschreibung von Ausführungsbeispielen sowie anhand der Zeichnungen, in welchen gleiche oder funktionsgleiche Elemente mit identischen Bezugszeichen versehen sind.

Dabei zeigen:
- Fig. 1: eine Seitenansicht eines Messsystems bei der Vermessung eines Aufzugschachts,
- Fig. 2: ein zweites Ausführungsbeispiel eines erfindungsgemässen Messsystems zur Vermessung eines Aufzugschachts und
- Fig. 3: ein drittes Ausführungsbeispiel eines erfindungsgemässen Messsystems zur Vermessung eines Aufzugschachts.

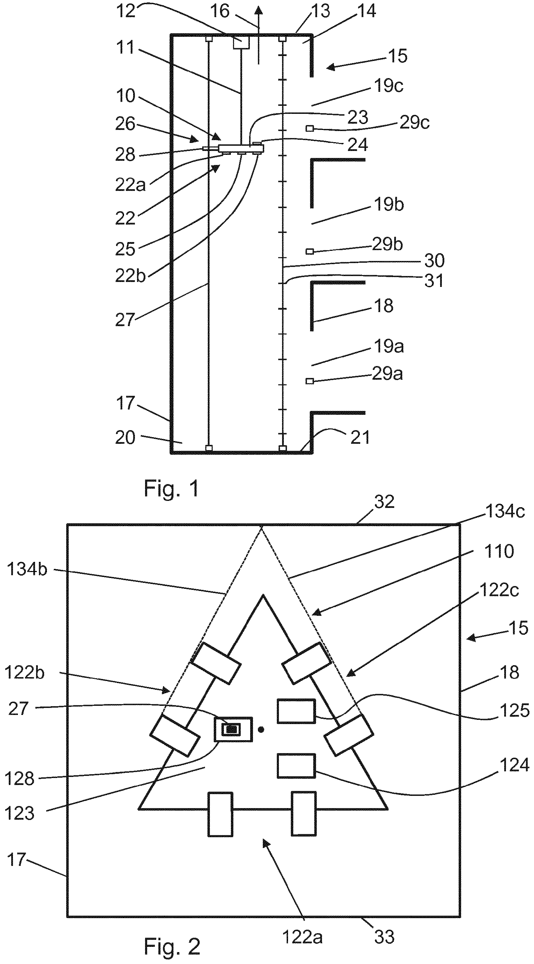

Gemäss Fig. 1 ist ein optisch inertiales Messsystem 10 über ein Tragmittel in Form eines Seils 11 und eine Verlagerungsvorrichtung in Form einer Winde 12 an einer Schachtdecke 13 eines Schachtkopfs 14 eines hauptsächlich quaderförmigen Aufzugschachts 15 aufgehängt. Der Aufzugschacht 15 verläuft in einer vertikal ausgerichteten Haupterstreckungsrichtung 16 und verfügt über insgesamt vier Schachtwände, wobei in der Seitenansicht von Fig. 1 nur eine hintere Schachtwand 17 und eine vordere Schachtwand 18 dargestellt sind. Die vordere Schachtwand 18 weist insgesamt drei Türöffnungen 19a, 19b, 19c auf, die in Haupterstreckungsrichtung 16 übereinander angeordnet sind. In die Schachtöffnungen 19a, 19b, 19c werden zu einem späteren Zeitpunkt Schachttüren eingebaut, die den Aufzugschacht 15 abschliessen und den Zugang zu einer Aufzugkabine ermöglichen. Gegenüber dem Schachtkopf 14 weist der Aufzugschacht 15 eine Schachtgrube 20 auf, die von einem Schachtboden 21 abgeschlossen wird.

Das Messsystem 10 weist ein Kamerasystem in Form einer digitalen Stereo-Kamera 22 mit einer ersten Kamera 22a und einer zweiten Kamera 22b auf. Die Stereo-Kamera 22 ist so an einem hauptsächlich quaderförmigen Grundkörper 23 des Messsystems 10 angeordnet, dass sie im dargestellten aufgehängten Zustand vertikal nach unten in Richtung Schachtboden 20 ausgerichtet ist. Die Stereo-Kamera 22 ist so ausgeführt, dass sie im dargestellten Zustand Ausschnitte aller vier Schachtwände erfassen kann. Die Stereo-Kamera 22 ist signaltechnisch mit einer Auswerteeinheit 24 des Messsystems 10 verbunden, das die von der Stereo-Kamera 22 erfassten Bilder empfängt und auswertet. Die Auswerteeinheit 24 sucht in den Bildern nach markanten Punkten, beispielsweise Ecken oder Erhebungen in einer der Schachtwände. Sobald sie einen markanten Punkt in beiden Bildern der Kameras 22a, 22b identifiziert hat, kann sie aus dem bekannten Abstand der beiden Kameras 22a, 22b zueinander und der verschiedenen Lage des markanten Punkts in beiden Bildern, mittels Triangulation die Lage des markanten Punkts gegenüber den Kameras 22a, 22b und damit gegenüber dem Messsystem 10 bestimmen.

Zwischen den beiden Kameras 22a, 22b ist eine inertiale Messeinheit 25 am Grundkörper 23 des Messsystems 10 angeordnet. Die inertiale Messeinheit 25 verfügt über drei nicht dargestellte, jeweils senkrecht zueinander angeordnete Beschleunigungssensoren und jeweils drei ebenfalls nicht dargestellte, senkrecht zueinander angeordnete Drehratensensoren, mittels welchen die Beschleunigungen in x-, y- und z-Richtung und die Drehbeschleunigungen um die x-, y- und z-Achse bestimmt werden. Aus den gemessenen Beschleunigungen kann die inertiale Messeinheit 25 ausgehend von einer Startposition seine Position und damit auch die Position des Messsystems 10 abschätzen und an die Auswerteeinheit 24 des Messsystems 10 übermitteln. Es ist auch möglich, dass die inertiale Messeinheit 25 nur die gemessenen Beschleunigungen an die Auswerteeinheit 24 übermittelt und die Auswerteeinheit 24 daraus die Position des Messsystems 10 abschätzt.

Zur genaueren Bestimmung der Position des Messsystems 10 in Haupterstreckungsrichtung 16 im Aufzugschacht 15 ist das Messsystem 10 mit einer Positionsbestimmungseinheit 26 gekoppelt. Die Positionsbestimmungseinheit 26 verfügt über einen in Haupterstreckungsrichtung 16 ausgerichteten Positionsinformationsträger in Form eines Codebands 27, das zwischen Schachtboden 21 und Schachtdecke 13 gespannt ist. Das Codeband 27 weist nicht sichtbare magnetische Codemarken auf, welche eine Information über die Position in Haupterstreckungsrichtung 16 repräsentieren. Die Positionsbestimmungseinheit 26 weist ausserdem eine seitlich am Grundkörper 23 des Messsystems 10 angeordnete Leseeinheit 28 auf, durch die das Codeband 27 durchgeführt ist. Das Codeband 27 wirkt damit einer Rotation des Messsystems 10 um eine Achse in Haupterstreckungsrichtung 16 und einer Verlagerung des Messsystems 10 quer zur Haupterstreckungsrichtung 16 entgegen und wirkt damit als eine Führung des Messsystems 10. Die Leseeinheit 28 liest Informationen in Form der magnetischen Codemarken des Codebands 27 aus und kann damit sehr genau die Position der Leseeinheit 28 und damit des Messsystems 10 in Haupterstreckungsrichtung 16 bestimmen. Die vom Codeband 27 ausgelesene Information kann damit als eine gegenüber den Informationen der Beschleunigungs- und Drehratensensoren der inertialen Messeinheit 25 weitere Information über die Position des Messsystems 10 in Haupterstreckungsrichtung 16 angesehen werden.

Die mittels der Positionsbestimmungseinheit 26 ermittelte Position des Messsystems 10 in Haupterstreckungsrichtung 16 wird als die korrekte Position des Messsystems 10 angesehen und ersetzt damit die mittels der inertialen Messeinheit 25 abgeschätzte Position der Messeinheit 10 in Haupterstreckungsrichtung. Es ist aber auch möglich, dass als korrekte Position ein Mittelwert der beiden genannten Positionen angenommen wird.

Aus der wie oben beschrieben bestimmten Position des Messsystems 10 und der mittels Triangulation bestimmten Lage eines markanten Punkts gegenüber dem Messsystem 10 bestimmt die Auswerteeinheit 24 die absolute Position des markanten Punkts. Die Auswerteeinheit 24 bestimmt so die Positionen einer Vielzahl von markanten Punkten und erstellt so ein digitales Modell des Aufzugschachts 15, das zunächst aus einer Vielzahl von einzelnen Punkten, also einer so genannten Punktwolke besteht. Zu einem späteren Zeitpunkt kann dann in einer Weiterbearbeitung der Daten, die üblicherweise nicht mehr von der Auswerteeinheit 24 durchgeführt wird, Linien und Flächen aus der Punktwolke abgeleitet werden. Um den ganzen Aufzugschacht 15 zu vermessen, wird das Messsystem 10 von der Winde 12 von oben nach unten im Aufzugschacht 15 verlagert.

In einer Nachbearbeitung des digitalen Modells des Aufzugschachts 15 wird ein Vergleich mit einem Soll-Modell des Aufzugschachts 15 durchgeführt. Es wird also geprüft, ob der reale Aufzugschacht 15 den Vorgaben entspricht. Falls zu grosse Abweichungen vorhanden sind, wird eine Nacharbeit verlangt und/oder eine Abnahme des Aufzugschachts 15 verweigert. Zusätzlich wird geprüft, ob ein geplanter Aufbau der Aufzuganlage in dem vermessenen Aufzugschacht 15 umgesetzt werden kann. Es wird also geprüft, ob die einzelnen Komponenten der Aufzuganlage, wie Aufzugkabine, Gegengewicht, Führungsschienen, etc. wie geplant eingebaut werden können. Ist dies nicht der Fall, werden Anpassungen am Aufzugschacht 15 und/oder am Aufbau der Aufzuganlage durchgeführt. Beispielsweise können an den Schachtwänden des Aufzugschachts 15 Änderungen vorgenommen, die Grösse der Aufzugkabine und/oder des Gegengewichts angepasst, andere Halter für Führungsschienen vorgesehen oder geplante Positionen der genannten Halter verschoben werden.

Statt oder ergänzend zur Verwendung der Positionsbestimmungseinheit 26 können weitere Informationen und Hilfsmittel zur Vermessung des Aufzugschachts 15 verwendet werden. Derartige Hilfsmittel sind ebenfalls in der Fig. 1 dargestellt. Im Bereich der Schachtöffnungen 19a, 19b, 19c ist an einer Schachtwand jeweils ein Referenzelement in Form einer Markierung 29a, 29b, 29c angeordnet. Die Markierungen 29a, 29b, 29c sind dabei insbesondere als so genannte Meterrisse ausgeführt, die einen Abstand von einem Meter vom späteren Bodenbelag kennzeichnen. Zu den Markierungen 29a, 29b, 29c ist jeweils die absolute Höhe über Normal-Null oder die relative Höhe über dem Schachtboden 21 bekannt. Damit sind die Positionen der Markierungen 29a, 29b, 29c in Haupterstreckungsrichtung 16 innerhalb des Aufzugschachts 15 bekannt. Die Auswerteeinheit 24 kann die Lage einer Markierung 29a, 29b, 29c gegenüber dem Messsystem 10 wie oben beschrieben bestimmen und auf Basis der bekannten Position der Markierung 29a, 29b, 29c in Haupterstreckungsrichtung und der genannten Lage auf die tatsächliche Position des Messsystems 10 in Haupterstreckungsrichtung 16 zurückschliessen. Diese so bestimmte tatsächliche Position des Messsystems 10 wird dann für die Vermessung des Aufzugschachts 15 verwendet. Die Position einer oder mehrerer der Markierungen 29a, 29b, 29c kann damit als eine gegenüber den Informationen der Beschleunigungs- und Drehratensensoren der inertialen Messeinheit 25 weitere Information über die Position des Messsystems 10 in Haupterstreckungsrichtung 16 angesehen werden.

Ergänzend oder zusätzlich zu den Markierungen 29a, 29b, 29c kann zwischen Schachtboden 21 und Schachtdecke 13 ein langgestrecktes Ausrichtelement in Form eines Seils 30 gespannt sein. Das Seil 30 verläuft insbesondere Haupterstreckungsrichtung 16, also hier in vertikaler Richtung. Es weist in einem definierten Abstand von beispielsweise einem Meter mehrere Referenzelemente in Form von Abstands-Markierungen 31 auf. Die Auswerteeinheit 24 kann die Positionen der Abstands-Markierungen 31 in Haupterstreckungsrichtung 16 wie beschrieben bestimmen und damit ihren Abstand zueinander berechnen. Durch einen Vergleich der berechneten Abstände mit den bekannten tatsächlichen Abständen kann eine Überprüfung und gegebenenfalls eine Korrektur der verwendeten Position des Messsystems 10 in Haupterstreckungsrichtung 16 durch die Auswerteeinheit 24 erfolgen. Der von der Auswerteeinheit 24 ermittelte Abstand der Abstands-Markierungen 31 kann damit als eine gegenüber den Informationen der Beschleunigungs- und Drehratensensoren der inertialen Messeinheit 25 weitere Information über die Position des Messsystems 10 in Haupterstreckungsrichtung 16 angesehen werden.

Das Seil 30 kann zusätzlich zur Verifizierung der Position des Messsystems 10 quer zur Haupterstreckungsrichtung 16 verwendet werden. Die genannte Verifizierung der ermittelten Position des optisch inertialen Messsystems kann dabei während des Vermessens oder auch nachträglich bei der Erstellung des digitalen Modells des Aufzugschachts erfolgen.

In Fig. 2 ist ein zum Messsystem 10 aus Fig. 1 alternatives Messsystem 110 in einer nicht massstäblichen Sicht von oben in einen Aufzugschacht 15 dargestellt. Das Messsystem 110 hat grundsätzlich die selbe Funktionalität wie das Messsystem 10 aus Fig. 1, so dass auch das Vermessen eines Aufzugschachts grundsätzlich gleich abläuft. Aus diesen Gründen wird nur auf die Unterschiede der Messsysteme eingegangen.

Das Messsystem 110 verfügt über einen Grundkörper 123 mit einem Querschnitt, der die Form eines gleichseitigen Dreiecks aufweist. Das Messsystem 110 ist während des Vermessens des Aufzugschachts 15 so ausgerichtet, dass der genannte Querschnitt quer, also senkrecht zur Haupterstreckungsrichtung des Aufzugschachts 15 liegt. Die Hauptstreckungsrichtung des Aufzugschachts 15 ist in Fig. 2 senkrecht zur Zeichenebene ausgerichtet.

An jeder Seite des genannten gleichseitigen Dreiecks ist jeweils eine Stereo-Kamera 122a, 122b, 122c so angeordnet, dass sie quer zur Haupterstreckungsrichtung ausgerichtet ist. Die Stereo-Kameras 122a, 122b, 122c sind damit in Richtung von Schachtwänden 17, 18, 32, 33 des Aufzugschachts 15 ausgerichtet. Es ist auch möglich, dass die Stereo- Kameras leicht geneigt gegenüber der Haupterstreckungsrichtung, insbesondere Richtung Schachtgrube, angeordnet sind.

Erfassungsbereiche der Stereo-Kameras 122a, 122b, 122c sind so ausgeführt, dass jeder Punkt des Aufzugsschachts 15, der ungefähr dieselbe Position in Haupterstreckungsrichtung wie das Messsystem 110 aufweist, von einer Stereo-Kamera 122a, 122b, 122c erfasst werden kann. Damit ist durch die drei Stereo-Kameras 122a, 122b, 122c bezogen auf die Haupterstreckungsrichtung eine Rundumsicht gewährleistet. Die Erfassungsbereiche der drei Stereo-Kameras 122a, 122b, 122c überlappen sich, was aber nicht zwingend notwendig ist. Zur Veranschaulichung sind in der Fig. 2 eine Grenzlinie 134b des Erfassungsbereichs der Stereo-Kamera 122b in Richtung Stereo-Kamera 122c und eine Grenzlinie 134c des Erfassungsbereichs der Stereo-Kamera 122c in Richtung Stereo-Kamera 122b dargestellt. Wie man der Fig. 2 entnehmen kann, schneiden sich die Grenzlinien 134b und 134c noch innerhalb des Aufzugschachts 15, so dass sich ein Überlappungsbereich zwischen den Erfassungsbereichen der beiden Stereo- Kameras 122b, 122c ergibt. Entsprechend ergeben sich Überlappungsbereiche zwischen allen Stereo-Kameras 122a, 122b, 122c.

Das Messsystem 110 weist zusätzlich eine Leseeinheit 128 für ein Codeband 27 einer Positionsbestimmungseinheit auf. Das Codeband 27 wird dabei durch die Leseeinheit 128 geführt, welche so hinter den drei Stereo-Kameras 122a, 122b, 122c angeordnet ist, dass die Leseeinheit 128 und das Codeband 27 von keiner der drei Stereo-Kameras 122a, 122b, 122c erfasst werden kann. Die Leseeinheit 128 und das Codeband 27 liegen also innerhalb keinem der Erfassungsbereiche der drei Stereo-Kameras 122a, 122b, 122c. Das Messsystem 110 verfügt ausserdem über eine Auswerteeinheit 124 und eine inertiale Messeinheit 125, welche ebenfalls so angeordnet ist, dass sie von keiner der drei Stereo- Kameras 122a, 122b, 122c erfasst werden können.

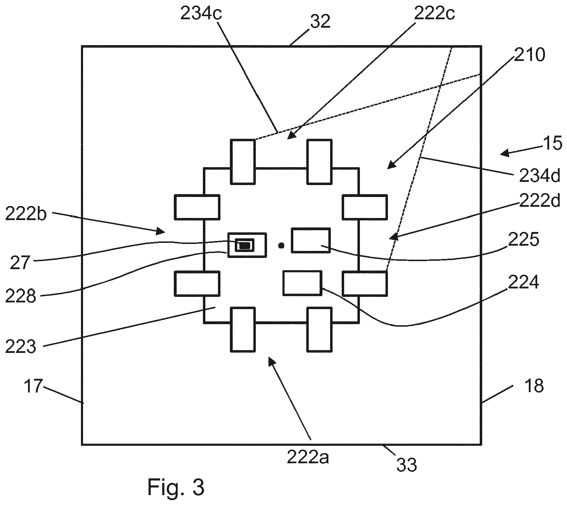

In Fig. 3 ist ein zum Messsystem 10 aus Fig. 1 und zum Messsystem 110 aus Fig. 2 alternatives Messsystem 210 in einer nicht massstäblichen Sicht von oben in einen Aufzugschacht 15 dargestellt. Das Messsystem 210 hat weitgehend denselben Aufbau wie das Messsystem 110 aus Fig. 2, so dass nur auf die Unterschiede der Messsysteme eingegangen wird.

Das Messsystem 210 verfügt über einen Grundkörper 223 mit einem Querschnitt, der die Form eines Quadrats aufweist. Das Messsystem 210 ist während des Vermessens des Aufzugschachts 15 so ausgerichtet, dass der genannte Querschnitt quer, also senkrecht zur Haupterstreckungsrichtung des Aufzugschachts 15 liegt.

An jeder Seite des genannten Quadrats ist jeweils eine Stereo-Kamera 222a, 222b, 222c, 222d so angeordnet, dass sie quer zur Haupterstreckungsrichtung ausgerichtet ist. Die Stereo-Kameras 222a, 222b, 222c, 222d sind damit direkt in Richtung von Schachtwänden 17, 18, 32, 33 des Aufzugschachts 15 ausgerichtet. Es ist auch möglich, dass die Stereo-Kameras leicht geneigt gegenüber der Haupterstreckungsrichtung, insbesondere Richtung Schachtgrube, angeordnet sind.

Erfassungsbereiche der Stereo-Kameras 222a, 222b, 222c, 222d sind so ausgeführt, dass jeder Punkt des Aufzugsschachts 15, der ungefähr dieselbe Position in Haupterstreckungsrichtung wie das Messsystem 210 aufweist, von einer Stereo-Kamera 222a, 222b, 222c, 222d erfasst werden kann. Damit ist durch die vier Stereo-Kameras 222a, 222b, 222c, 222d bezogen auf die Haupterstreckungsrichtung eine Rundumsicht gewährleistet. Die Erfassungsbereiche der vier Stereo-Kameras 222a, 222b, 222c, 222d überlappen sich, was aber nicht zwingend notwendig ist. Zur Veranschaulichung sind in der Fig. 3 eine Grenzlinie 234c des Erfassungsbereichs der Stereo-Kamera 222c in Richtung Stereo-Kamera 222d und eine Grenzlinie 234d des Erfassungsbereichs der Stereo-Kamera 222d in Richtung Stereo-Kamera 222c dargestellt. Wie man der Fig. 3 entnehmen kann, schneiden sich die Grenzlinien 234c und 234d noch innerhalb des Aufzugschachts 15, so dass sich ein Überlappungsbereich zwischen den Erfassungsbereichen der beiden Stereo-Kameras 222c, 222d ergibt. Entsprechend ergeben sich Überlappungsbereiche zwischen allen Stereo-Kameras 222a, 222b, 222c, 222d.

Das Messsystem 210 weist zusätzlich eine Leseeinheit 228 für ein Codeband 27, eine Auswerteeinheit 224 und eine inertiale Messeinheit 225 auf. Die Leseeinheit 228, das Codeband 27, die Auswerteeinheit 224 und die inertiale Messeinheit 225 sind dabei so angeordnet, dass sie von keiner der drei Stereo-Kameras 222a, 222b, 222c, 222d erfasst werden können.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zur Analyse eines hauptsächlich in einer Haupterstreckungsrichtung (16) verlaufenden Aufzugschachts (15) einer Aufzuganlage, bei welchem der Aufzugschacht (15) mittels eines ein Kamerasystem (22, 122a, 122b, 122c, 222a, 222b, 222c, 222d) aufweisenden Messsystems (10, 110, 210) vermessen wird und auf Grund bei der Vermessung ermittelten Daten ein digitales Modell des Aufzugschachts (15) erstellt wird,
**dadurch gekennzeichnet, dass**
die Vermessung mittels eines Messsystems (10, 110, 210) erfolgt, welches zusätzlich zum genannten Kamerasystem (22, 122a, 122b, 122c, 222a, 222b, 222c, 222d) eine inertiale Messeinheit (25, 125, 225) mit Beschleunigungs- und Drehratensensoren aufweist, mittels welcher eine Position des Messsystems (10, 110, 210) im Aufzugschacht (15) abgeschätzt werden kann, und
zur Erstellung des digitalen Modells des Aufzugschachts (15) zusätzlich zu den Informationen der Beschleunigungs- und Drehratensensoren der inertialen Messeinheit (25, 125, 225) eine weitere Information über die Position des Messsystems (10, 110, 210) in Haupterstreckungsrichtung (16) erfasst und ausgewertet wird.

2. Verfahren nach Anspruch 1,
**dadurch gekennzeichnet, dass**
das Messsystem (110, 210) wenigstens drei Stereo-Kameras (122a, 122b, 122c, 222a, 222b, 222c, 222d) aufweist, welche beim Vermessen des Aufzugschachts (15) so quer zur Haupterstreckungsrichtung (16) angeordnet sind, dass eine Rundumsicht gewährleistet ist.

3. Verfahren nach Anspruch 1 oder 2,
**dadurch gekennzeichnet, dass**
das Messsystem (10, 110, 210) mit einer Positionsbestimmungseinheit (26) gekoppelt ist, welche eine Position des Messsystems (10, 110, 210) in Haupterstreckungsrichtung (16) bestimmt und diese Position als weitere Information über die Position des Messsystems (10, 110, 210) in Haupterstreckungsrichtung (16) erfasst und ausgewertet wird.

4. Verfahren nach Anspruch 2 und 3,
**dadurch gekennzeichnet, dass**
die Positionsbestimmungseinheit (26) eine Information über die Position des Messsystems (10, 110, 210) in Haupterstreckungsrichtung (16) mittels eines langestreckten und in Haupterstreckungsrichtung (16) ausgerichteten Positionsinformationsträgers (27) bestimmt und die Stereo-Kameras (122a, 122b, 122c, 222a, 222b, 222c, 222d) und der Positionsinformationsträger (27) so zueinander angeordnet sind, dass der Positionsinformationsträger (27) von keiner der Stereo- Kameras (122a, 122b, 122c, 222a, 222b, 222c, 222d) erfasst wird.

5. Verfahren nach einem der Ansprüche 1 bis 4,
**dadurch gekennzeichnet, dass**
vor der Vermessung mit dem Messsystem (10, 110, 210) wenigstens ein Referenzelement (29a, 29b, 29c, 31) im Aufzugschacht (15) angeordnet wird, welches bei der Vermessung vom optischen inertialen Messsystem (10, 110, 210) erfasst und die über das Referenzelement (29a, 29b, 29c, 31) erfasste Information als weitere Information über die Position des Messsystems (10, 110, 210) in Haupterstreckungsrichtung (16) zur Erstellung des digitalen Modells des Aufzugschachts (15) ausgewertet wird.

6. Verfahren nach Anspruch 5,
**dadurch gekennzeichnet, dass**
das wenigstens ein Referenzelement (29a, 29b, 29c) an einer bekannten Position in Haupterstreckungsrichtung (16) im Aufzugschacht (15) angeordnet wird und diese bekannte Position zur Erstellung des digitalen Modells des Aufzugschachts (15) ausgewertet wird.

7. Verfahren nach Anspruch 5 oder 6,
**dadurch gekennzeichnet, dass**
zwei Referenzelemente (31) in einem bekannten Abstand zueinander in Haupterstreckungsrichtung (16) im Aufzugschacht (15) angeordnet werden und dieser bekannte Abstand zur Erstellung des digitalen Modells des Aufzugschachts (15) ausgewertet wird.

8. Verfahren nach einem der Ansprüche 1 bis 7,
**dadurch gekennzeichnet, dass**
vor der Vermessung mit dem Messsystem (10, 110, 210) ein langgestrecktes, hauptsächlich in Haupterstreckungsrichtung (16) verlaufendes Ausrichtelement (30) im Aufzugschacht (15) angeordnet wird, welches zur Verifizierung der ermittelten Position des Messsystems (10, 110, 210) verwendet wird.

9. Verfahren nach einem der Ansprüche 1 bis 8,
**dadurch gekennzeichnet, dass**
nach der Erstellung des digitalen Modells des Aufzugschachts (15) ein Vergleich mit einem Soll-Modell des Aufzugschachts (15) durchgeführt wird.

10. Verfahren nach einem der Ansprüche 1 bis 9,
**dadurch gekennzeichnet, dass**
nach der Erstellung des digitalen Modells des Aufzugschachts (15) geprüft wird, ob ein geplanter Aufbau der Aufzuganlage in dem vermessenen Aufzugschacht (15) umgesetzt werden kann.

11. Verfahren nach Anspruch 10,
**dadurch gekennzeichnet, dass**
wenn der geplante Aufbau der Aufzuganlage in dem vermessenen Aufzugschacht (15) nicht umgesetzt werden kann, Anpassungen am Aufzugschacht (15) und/oder am Aufbau der Aufzuganlage durchgeführt werden.

12. Messsystem zum Vermessen eines hauptsächlich in einer Haupterstreckungsrichtung (16) verlaufenden Aufzugschachts (15) einer Aufzuganlage mit einem Kamerasystem (22, 122a, 122b, 122c, 222a, 222b, 222c, 222d),
**gekennzeichnet durch**
- eine inertiale Messeinheit (125, 225) mit Beschleunigungs- und Drehratensensoren, mittels welcher eine Position des Messsystems (10, 110, 210) im Aufzugschacht (15) abgeschätzt werden kann,
- eine Auswerteeinheit (24, 124, 2248), welche dafür vorgesehen ist, zur Erstellung eines digitalen Modells des Aufzugschachts (15) zusätzlich zu den Informationen der Beschleunigungs- und Drehratensensoren der inertialen Messeinheit (25, 125, 225) eine weitere Information über die Position des Messsystems (10, 110, 210) in Haupterstreckungsrichtung (16) zu erfassen und auszuwerten.

13. Messsystem nach Anspruch 12,
**gekennzeichnet durch**
- wenigstens drei Stereo-Kameras (122a, 122b, 122c, 222a, 222b, 222c, 222d), welche beim Vermessen des Aufzugschachts (15) so quer zur Haupterstreckungsrichtung (16) angeordnet sind, dass bezogen auf die Haupterstreckungsrichtung (16) eine Rundumsicht gewährleistet ist und
- eine Leseeinheit (128, 228) einer Positionsbestimmungseinheit zum Auslesen von Informationen eines Positionsinformationsträgers (27), mittels welcher eine Position des Messsystems (110, 210) in Haupterstreckungsrichtung (16) bestimmbar ist.

14. Messsystem nach Anspruch 12,
**dadurch gekennzeichnet, dass**
die Leseeinheit (128, 228) der Positionsbestimmungseinheit und die Stereo-Kameras (122a, 122b, 122c, 222a, 222b, 222c, 222d) so zueinander angeordnet sind, dass die Leseeinheit (128, 228) von keiner der Stereo-Kameras (122a, 122b, 122c, 222a, 222b, 222c, 222d) erfassbar ist.

## Claims

1. Method for analyzing an elevator shaft (15) of an elevator system, which shaft extends mainly in a main extension direction (16), in which method the elevator shaft (15) is surveyed by means of a measurement system (10, 110, 210) comprising a camera system (22, 122a, 122b, 122c, 222a, 222b, 222c, 222d) and a digital model of the elevator shaft (15) is created on the basis of data determined during the survey,
**characterized in that**
the survey is carried out by means of a measurement system (10, 110, 210) that, in addition to said camera system (22, 122a, 122b, 122c, 222a, 222b, 222c, 222d), also comprises an inertial measurement unit (25, 125, 225), which has acceleration and angular-rate sensors and by means of which a position of the measurement system (10, 110, 210) in the elevator shaft (15) can be estimated, and
further information on the position of the measurement system (10, 110, 210) in the main extension direction (16), in addition to the information from the acceleration and angular rate sensors of the inertial measurement unit (25, 125, 225), is recorded and analyzed to create the digital model of the elevator shaft (15).

2. Method according to claim 1,
**characterized in that**
the measurement system (110, 210) comprises at least three stereo cameras (122a, 122b, 122c, 222a, 222b, 222c, 222d) which, during the survey of the elevator shaft (15), are arranged transversely to the main extension direction (16) such that an all-round view is ensured.

3. Method according to either claim 1 or claim 2,
**characterized in that**
the measurement system (10, 110, 210) is coupled to a position determination unit (26), which determines a position of the measurement system (10, 110, 210) in the main extension direction (16), and this position is recorded and analyzed as further information on the position of the measurement system (10, 110, 210) in the main extension direction (16).

4. Method according to claims 2 and 3,
**characterized in that**
the position determination unit (26) determines information on the position of the measurement system (10, 110, 210) in the main extension direction (16) by means of an elongate positional information carrier (27) oriented in the main extension direction (16), and the stereo cameras (122a, 122b, 122c, 222a, 222b, 222c, 222d) and the positional information carrier (27) are arranged relative to one another such that the positional information carrier (27) is not recorded by any of the stereo cameras (122a, 122b, 122c, 222a, 222b, 222c, 222d).

5. Method according to any of claims 1 to 4,
**characterized in that**,
before the survey by means of the measurement system (10, 110, 210), at least one reference element (29a, 29b, 29c, 31) is arranged in the elevator shaft (15) and is recorded by the optical internal measurement system (10, 110, 210) during the survey, and the recorded information on the reference element (29a, 29b, 29c, 31) is analyzed as further information on the position of the measurement system (10, 110, 210) in the main extension direction (16) in order to create the digital model of the elevator shaft (15).

6. Method according to claim 5,
**characterized in that**
the at least one reference element (29a, 29b, 29c) is arranged at a known position in the main extension direction (16) in the elevator shaft (15) and this known position is analyzed in order to create the digital model of the elevator shaft (15).

7. Method according to either claim 5 or claim 6,
**characterized in that**
two reference elements (31) are arranged in the elevator shaft (15) at a known distance from one another in the main extension direction (16) and this known distance is analyzed in order to create the digital model of the elevator shaft (15).

8. Method according to any of claims 1 to 7,
**characterized in that**,
before the survey by means of the measurement system (10, 110, 210), an elongate orientation element (30) extending mainly in the main extension direction (16) is arranged in the elevator shaft (15) and is used to verify the established position of the measurement system (10, 110, 210).

9. Method according to any of claims 1 to 8,
**characterized in that**,
after the digital model of the elevator shaft (15) has been created, said model is compared with a target model of the elevator shaft (15).

10. Method according to any of claims 1 to 9,
**characterized in that**,
after the digital model of the elevator shaft (15) has been created, a check is carried out as to whether a planned design of the elevator system can be implemented in the surveyed elevator shaft (15).

11. Method according to claim 10,
**characterized in that**,
if the planned design of the elevator system cannot be implemented in the surveyed elevator shaft (15), adjustments are made to the elevator shaft (15) and/or to the design of the elevator system.

12. Measurement system for surveying an elevator shaft (15) of an elevator system, which shaft extends mainly in a main extension direction (16), by means of a camera system (22, 122a, 122b, 122c, 222a, 222b, 222c, 222d),
**characterized by**
- an inertial measurement unit (125, 225) that has acceleration and angular rate sensors and by means of which a position of the measurement system (10, 110, 210) in the elevator shaft (15) can be estimated,
- an evaluation unit (24, 124, 2248) provided for recording and evaluating further information on the position of the measurement system (10, 110, 210) in the main extension direction (16), in addition to the information from the acceleration and angular rate sensors of the inertial measurement unit (25, 125, 225), in order to create a digital model of the elevator shaft (15).

13. Measurement system according to claim 12,
**characterized by**
- at least three stereo cameras (122a, 122b, 122c, 222a, 222b, 222c, 222d), which, during the survey of the elevator shaft (15), are arranged transversely to the main extension direction (16) such that an all-round view in relation to the main extension direction (16) is ensured, and
- a reading unit (128, 228) of a position determination unit for reading out information of a positional information carrier (27), by means of which unit a position of the measurement system (110, 210) in the main extension direction (16) can be determined.

14. Measurement system according to claim 12,
**characterized in that**
the reading unit (128, 228) of the position determination unit and the stereo cameras (122a, 122b, 122c, 222a, 222b, 222c, 222d) are arranged relative to one another such that the reading unit (128, 228) cannot be recorded by any of the stereo cameras (122a, 122b, 122c, 222a, 222b, 222c, 222d).

## Revendications

1. Procédé d'analyse d'une cage d'ascenseur (15) d'une installation d'ascenseur, laquelle cage d'ascenseur s'étend principalement dans une direction longitudinale principale (16), la cage d'ascenseur (15) étant mesurée au moyen d'un système de mesure (10, 110, 210) présentant un système de caméra (22, 122a, 122b, 122c, 222a, 222b, 222c, 222d), et un modèle numérique de la cage d'ascenseur (15) étant créé sur la base de données déterminées lors de la mesure,
**caractérisé en ce que**
la mesure est effectuée au moyen d'un système de mesure (10, 110, 210) qui, en complément du système de caméra susmentionné (22, 122a, 122b, 122c, 222a, 222b, 222c, 222d), présente une unité de mesure par inertie (25, 125, 225) comportant des capteurs d'accélération et de vitesse de rotation, lesquels permettent d'estimer une position du système de mesure (10, 110, 210) dans la cage d'ascenseur (15), et
une information supplémentaire concernant la position du système de mesure (10, 110, 210) dans la direction longitudinale principale (16) est détectée et évaluée en complément des informations des capteurs d'accélération et de vitesse de rotation de l'unité de mesure par inertie (25, 125, 225) afin de créer le modèle numérique de la cage d'ascenseur (15).

2. Procédé selon la revendication 1,
**caractérisé**
**en ce que** le système de mesure (110, 210) présente au moins trois caméras stéréo (122a, 122b, 122c, 222a, 222b, 222c, 222d) qui, lors de la mesure de la cage d'ascenseur (15), sont disposées transversalement à la direction longitudinale principale (16) de manière à garantir une vue panoramique.

3. Procédé selon la revendication 1 ou 2,
**caractérisé**
**en ce que** le système de mesure (10, 110, 210) est couplé à une unité de détermination de position (26), laquelle détermine une position du système de mesure (10, 110, 210) dans la direction longitudinale principale (16), et cette position est détectée et évaluée en tant qu'information supplémentaire concernant la position du système de mesure (10, 110, 210) dans la direction longitudinale principale (16).

4. Procédé selon les revendications 2 et 3,
**caractérisé**
**en ce que** l'unité de détermination de position (26) détermine une information concernant la position du système de mesure (10, 110, 210) dans la direction longitudinale principale (16) au moyen d'un support d'informations de position (27), lequel est allongé et orienté dans la direction longitudinale principale (16), et les caméras stéréo (122a, 122b, 122c, 222a, 222b, 222c, 222d) et le support d'informations de position (27) sont disposés les uns par rapport aux autres de telle sorte que le support d'informations de position (27) n'est détecté par aucune des caméras stéréo (122a, 122b, 122c, 222a, 222b, 222c, 222d).

5. Procédé selon l'une des revendications 1 à 4,
**caractérisé**
**en ce que**, avant la mesure à l'aide du système de mesure (10, 110, 210), au moins un élément de référence (29a, 29b, 29c, 31), qui est détecté lors de la mesure par le système de mesure optique par inertie (10, 110, 210), est disposé dans la cage d'ascenseur (15), et l'information détectée par l'intermédiaire de l'élément de référence (29a, 29b, 29c, 31) est évaluée en tant qu'information supplémentaire concernant la position du système de mesure (10, 110, 210) dans la direction longitudinale principale (16), afin de créer le modèle numérique de la cage d'ascenseur (15).

6. Procédé selon la revendication 5,
**caractérisé**
**en ce que** l'au moins un élément de référence (29a, 29b, 29c) est disposé à une position connue dans la direction longitudinale principale (16) dans la cage d'ascenseur (15), et cette position connue est évaluée afin de créer le modèle numérique de la cage d'ascenseur (15).

7. Procédé selon la revendication 5 ou 6,
**caractérisé**
**en ce que** deux éléments de référence (31) sont disposés à une distance connue l'un de l'autre dans la direction longitudinale principale (16) dans la cage d'ascenseur (15), et cette distance connue est évaluée afin de créer le modèle numérique de la cage d'ascenseur (15).

8. Procédé selon l'une des revendications 1 à 7,
**caractérisé**
**en ce que**, avant la mesure à l'aide du système de mesure (10, 110, 210), un élément d'alignement (30), qui est allongé et s'étend principalement dans la direction longitudinale principale (16), est disposé dans la cage d'ascenseur (15), lequel élément d'alignement sert à vérifier la position déterminée du système de mesure (10, 110, 210).

9. Procédé selon l'une des revendications 1 à 8,
**caractérisé**
**en ce qu'**après la création du modèle numérique de la cage d'ascenseur (15), une comparaison avec un modèle de consigne de la cage d'ascenseur (15) est effectuée.

10. Procédé selon l'une des revendications 1 à 9,
**caractérisé**
**en ce qu'**après la création du modèle numérique de la cage d'ascenseur (15), on vérifie si un montage planifié de l'installation d'ascenseur dans la cage d'ascenseur mesurée (15) peut être mis en œuvre.

11. Procédé selon la revendication 10,
**caractérisé**
**en ce que** si le montage planifié de l'installation d'ascenseur dans la cage d'ascenseur mesurée (15) ne peut pas être mis en œuvre, des ajustements au niveau de la cage d'ascenseur (15) et/ou du montage de l'installation d'ascenseur sont effectués.

12. Système de mesure permettant de mesurer une cage d'ascenseur (15) d'une installation d'ascenseur, laquelle cage d'ascenseur s'étend principalement dans une direction longitudinale principale (16), à l'aide d'un système de caméra (22, 122a, 122b, 122c, 222a, 222b, 222c, 222d),
**caractérisé par**
- une unité de mesure par inertie (125, 225) comportant des capteurs d'accélération et de vitesse de rotation, lesquels permettent d'estimer une position du système de mesure (10, 110, 210) dans la cage d'ascenseur (15),
- une unité d'évaluation (24, 124, 2248), laquelle est prévue pour détecter et évaluer une information supplémentaire concernant la position du système de mesure (10, 110, 210) dans la direction longitudinale principale (16) en complément des informations des capteurs d'accélération et de vitesse de rotation de l'unité de mesure par inertie (25, 125, 225), afin de créer un modèle numérique de la cage d'ascenseur (15).

13. Système de mesure selon la revendication 12,
**caractérisé par**
- au moins trois caméras stéréo (122a, 122b, 122c, 222a, 222b, 222c, 222d), lesquelles sont disposées transversalement à la direction longitudinale principale (16) lors de la mesure de la cage d'ascenseur (15), de manière à garantir une vue panoramique par rapport à la direction longitudinale principale (16), et
- une unité de lecture (128, 228) d'une unité de détermination de position, laquelle est destinée à lire des informations d'un support d'informations de position (27) et permet de déterminer une position du système de mesure (110, 210) dans la direction longitudinale principale (16).

14. Système de mesure selon la revendication 12,
**caractérisé**
**en ce que** l'unité de lecture (128, 228) de l'unité de détermination de position et les caméras stéréo (122a, 122b, 122c, 222a, 222b, 222c, 222d) sont disposées les unes par rapport aux autres, de telle sorte que l'unité de lecture (128, 228) ne peut être détectée par aucune des caméras stéréo (122a, 122b, 122c, 222a, 222b, 222c, 222d).
